# EUROPÄISCHE PATENTSCHRIFT

(11) **EP 1 101 136 B1**
(45) Veröffentlichungstag und Bekanntmachung des Hinweises auf die Patenterteilung: **27.06.2007**
(21) Anmeldenummer: 99936534.9
(22) Anmeldetag: 14.07.1999
(51) Int. Cl.: G02B 6/42, H04B 10/24, H01L 31/12

(54) **OPTOELEKTRONISCHE SENDE- UND EMPFANGSEINHEIT**
OPTOELECTRONIC TRANSCEIVER
UNITE D'EMISSION ET DE RECEPTION OPTOELECTRONIQUE

(30) Priorität: 29.07.1998 DE 19834090
(43) Veröffentlichungstag der Anmeldung: 23.05.2001
(73) Patentinhaber: Dr. Johannes Heidenhain GmbH, 83292 Traunreut (DE)
(72) Erfinder: EISENBERGER, Christian, D-83324 Ruhpolding (DE); PRONOLD, Herbert, D-83301 Traunreut (DE); SPECKBACHER, Peter, D-84558 Kirchweidach (DE)
(86) Internationale Anmeldenummer: PCT/EP1999/004972
(87) Internationale Veröffentlichungsnummer: WO 2000/007052

(56) Entgegenhaltungen:
- EP-A- 0 053 742
- EP-A- 0 120 457
- EP-A- 0 290 242
- DE-A1- 2 629 356
- DE-A1- 3 109 887
- DE-A1- 19 727 632
- FR-A- 2 443 071
- GB-A- 2 136 239
- US-A- 4 292 512
- US-A- 5 140 152

## Beschreibung

Die vorliegende Erfindung betrifft eine optoelektronische Sende- und Empfangseinheit gemäß dem Oberbegriff des Anspruches 1, die insbesondere zur bidirektionalen Datenübertragung mittels Lichtwellenleitern geeignet ist.

Zur bidirektionalen Datenübertragung über Lichtwellenleiter sind an den jeweiligen Enden der Lichtwellenleiter optoelektronische Sende- und Empfangseinheiten bzw. sogenannte Transceiver erforderlich. Eine Möglichkeit zur Ausgestaltung derartiger Transceiver ist z.B. aus der EP 0 410 143 A2 bekannt. Dort ist vorgesehen, eine optoelektronische Sendeeinheit und eine optoelektronische Empfangseinheit in einem Winkel von 90° relativ zueinander anzuordnen. Über ein geeignetes Verzweiger- oder Strahlteilerelement wird sichergestellt, daß die von der Sendeeinheit emittierte Strahlung in einen Lichtwellenleiter eingekoppelt wird bzw. die vom Lichtwellenleiter kommende Strahlung in Richtung der Empfangseinheit umgelenkt wird. Derartige Transceiver erfordern jedoch einen großen Aufwand hinsichtlich der exakten Justage bzw. Anordnung der beiden Sende- und Empfangseinheiten in Bezug auf das Verzweigerelement und den Lichtwellenleiter. Außerdem erfordert diese Anordnung stets ein entsprechendes Verzweigerelement, d.h. die Anzahl nötiger Bauteile ist hoch.

In der JP 8-179169 ist aus diesem Grund deshalb vorgesehen, die Sendeeinheit und die Empfangseinheit entlang einer gemeinsamen optischen Achse anzuordnen, wobei diese Achse mit der optischen Achse des Lichtwellenleiters identisch ist. Benachbart zur Austrittsfläche des Lichtwellenleiters ist hierbei die Empfangseinheit angeordnet; dahinter bzw. abgewandt vom Lichtwellenleiter folgt die Sendeeinheit. Derart erübrigt sich das Verzweigerelement, wie es etwa in der Anordnung aus der oben zitierten Druckschrift nötig war. Die von der Sendeeinheit emittierte Strahlung wird in eine SiO₂-Wellenleiterschicht auf einem Trägersubstrat eingekoppelt, an der Empfangseinheit vorbeigeführt und von der Wellenleiterschicht in den Lichtwellenleiter eingekoppelt. Desweiteren wird vorgeschlagen, die Empfangs- bzw. Sendewellenlänge der beiden -einheiten aufeinander abzustimmen. So emittiert die entsprechende Sendeeinheit bei einer Wellenlänge, bei der die jeweilige Empfangseinheit nicht anspricht.
Problematisch an einer derartigen Anordnung ist nunmehr der erforderliche hohe fertigungstechnische Aufwand, da auf das Halbleiter-Trägersubstrat zunächst die Wellenleiterschicht aufgebracht werden muß und darauf wiederum die Halbleiterschichtstapel der Sende- und Empfangseinheiten. Es sind somit aufwendige Halbleiter-Herstellungstechniken zur Fertigung dieser Baueinheit erforderlich. Desweiteren resultieren bei der vorgeschlagenen Anordnung Probleme, wenn die von der Sendeeinheit emittierte Strahlung in die Wellenleiterschicht und von dieser in den Lichtwellenleiter eingekoppelt wird. Einkoppelverluste lassen sich an diesen Stellen kaum vermeiden, wounter wiederum die Gesamteffizienz dieser Anordnung leidet. Desweiteren ist aufzuführen, daß die jeweils aktiven Schichtbereiche der beiden Halbleiterbauelemente derart in Bezug zur optischen Achse ausgerichtet sind, daß diese in der jeweiligen Ebene der aktiven Bereiche liegt oder aber parallel hierzu orientiert ist. Abhängig von der Art und Weise der Beaufschlagung dieses Elementes mit der Strahlung, die die Austrittsfläche des Lichtwellenleiters verläßt, ergeben sich zusätzliche Probleme. So resultieren etwa im Fall einer direkten Bestrahlung dieses Elementes über den Lichtwellenleiter Justageprobleme. Es muß dann eine relativ schmale Fläche des Empfangselementes relativ zum auskoppelseitigen Ende des Lichtwellenleiters möglichst hochexakt ausgerichtet werden, was bei der Montage einen entsprechenden Aufwand erfordert. Ist hingegen eine Beaufschlagung über die Einkopplung der Strahlung des Lichtwellenleiters in die Wellenleiterschicht auf dem Substrat vorgesehen, so ergeben sich wiederum die bereits oben diskutierten Verluste bzw. Probleme beim Ein- und Auskoppeln dieser Strahlung.

Eine gattungsgemäße Vorrichtung ist aus der US 4,292,512 bekannt. Die in dieser Druckschrift vorgeschlagene optoelektronische Sende- und Empfangseinheit erüllt jedoch insbesondere nicht die Anforderungen hinsichtlich einer möglichst großen Justageunempfindlichkeit bei der Fetigung. So ist aufgrund der entsprechenden Geometrie nach wie vor eine recht präzise Ausrichtung der Sendeeinheit relativ zur Empfangseinheit erforderlich

Aus der ebenfalls gattungsgemäßen DE 31 09 887 A1 ist eine optoelektronische Sende- und Empfangseinheit bekannt, bei der Lichtsender und Lichtempfänger hintereinander angeordnet sind. Eine der beiden Einheiten weist hierbei eine optische Durchgangsöffnung auf.

Die DE 197 27 632 offenbart ein weiteres Bauteil zur bidirektionalen optischen Datenübertragung, bei dem ein Detektorchip und ein Emitterchip konzentrisch zur optischen Systemachse auf einer Schaltkreisplatine angeordnet werden.

Aus der DE 26 29 356 ist ferner eine optoelektronische Anordnung bekannt, die zwei in Strahlrichtung übereinander angeordnete Sende- oder Empfangsdioden umfasst. Je nach Ausführung der ersten oder zweiten Diode ist hierbei vorgesehen, die eine oder andere Diode durchlässig für die emittierte Wellenlänge der anderen Diode auszugestalten.

Aufgabe der vorliegenden Erfindung ist es, die gattungsgemäße optoelektronische Sende- und Empfangseinheit zur bidirektionalen Datenübertragung mittels Lichtwellenleitern derart weiterzubilden, daß insbesondere eine nochmals gesteigerte Unempfindlichkeit hinsichtlich der Justierung der einzelnen Elemente relativ zum Lichtwellenleiter und damit ein verringerter Montageaufwand resultiert. Desweiteren ist eine möglichst einfache Fertigung einer derartigen Vorrichtung wünschenswert.

Diese Aufgabe wird gelöst durch eine optoelektronische Sende- und Empfangseinheit mit den Merkmalen im kennzeichnenden Teil des Patentanspruches 1.

Vorteilhafte Ausführungsformen der erfindungsgemäßen optoelektronischen Sende- und Empfangseinheit ergeben sich aus den Maßnahmen in den abhängigen Patentansprüchen.

Erfindungsgemäß wird nunmehr vorgesehen, zumindest den aktiven, strahlungsempfindlichen Schichtbereich der Empfangseinheit senkrecht zu derjenigen Achse anzuordnen, entlang der die Empfangseinheit und die Sendeeinheit angeordnet sind. Vorzugsweise ist diese Achse durch die optische Symmetrieachse des Lichtwellenleiters vorgegeben. Diese Anordnung wird insbesondere durch die erfindungsgemäße Verwendung spezieller optoelektronischer Empfangseinheiten möglich, bei denen sich der aktive Schichtbereich in einer dünnen Membran befindet, die von der Sendeeinheit durchstrahlt werden kann. Da die strahlungsempfindliche Fläche der Empfangseinheit nunmehr relativ groß gegenüber der Endfläche bzw. Austrittsfläche des Lichtwellenleiters ist, resultiert zumindest für die optoelektronische Empfangseinheit ein entsprechend großer Toleranzbereich, innerhalb dessen dieses Element korrekt justiert vor der Austrittsfläche des Lichtwellenleiters montiert werden kann.

Darüberhinaus kann auch die Sendeeinheit derart in Bezug auf die optische Achse angeordnet werden, daß die Ebene des aktiven, lichtemittierenden Bereiches ebenfalls senkrecht zur optischen Achse orientiert ist. Grundsätzlich ist exakte Ausrichtung dieses Bauteiles aufgrund der üblichen Abstrahlcharakteristiken in Bezug auf den Lichtwellenleiter jedoch weniger kritisch, so daß diese Maßnahme optional vorgesehen werden kann.

Da desweiteren ein unmittelbares Durchstrahlen der Empfangseinheit durch die von der Sendeeinheit emittierte Strahlung vorgesehen ist, entfallen die oben diskutierten Probleme im Zusammenhang mit der ansonsten erforderlichen Wellenleiterschicht auf einem Trägersubstrat.

Es existieren grundsätzlich eine Reihe von Möglichkeiten, wie die beiden Sende- und Empfangseinheiten relativ zueinander geeignet angeordnet werden können und wie insbesondere die Kontaktierung der jeweiligen Sende- und Empfangseinheiten erfolgen kann.

Als weiterer Vorteil ist aufzuführen, daß der erforderliche Lichtwellenleiter in der erfindungsgemäßen Vorrichtung lediglich relativ grob gegenüber den optoelektronischen Bauteilen ausgerichtet und an einem geeigneten Gehäuse fixiert werden muß, wozu vorzugsweise eine geeignete Steckverbindung vorgesehen wird. Demgegenüber erforderten die Varianten gemäß dem Stand der Technik ein separates Modulgehäuse, aus dem der hochpräzise justierte Lichtwellenleiter in Form eines sog. "pigtails" herausgeführt wird, der wiederum über geeignete Kopplungselemente mit einem nachfolgenden Lichtwellenleiter verbunden werden muß.

Weitere Vorteile sowie Einzelheiten der erfindungsgemäßen optoelektronischen Sende- und Empfangseinheit ergeben sich aus der nachfolgenden Beschreibung verschiedener Ausführungsbeispiele anhand der beiliegenden Figuren.

Dabei zeigt
- Figur 1: eine schematische Darstellung eines ersten Ausführungsbeispiels der erfindungsgemäßen optoelektronischen Sende- und Empfangseinheit;
- Figur 2: eine zweite Ausführungsform der erfindungsgemäßen optoelektronischen Sende- und Empfangseinheit in einer schematischen Darstellung;
- Figur 3: eine dritte Ausführungsform der erfindungsgemäßen optoelektronischen Sende- und Empfangseinheit in einer schematischen Darstellung;
- Figur 4a und 4b: verschiedene Ansichten einer vierten Ausführungsform der erfindungsgemäßen optoelektronischen Sende- und Empfangseinheit;
- Figur 5: eine weitere optoelektronische Sende- und Empfangseinheit in einer schematischen Darstellung;
- Figur 6: eine weitere optoelektronische Sende- und Empfangseinheit in einer schematischen Darstellung.

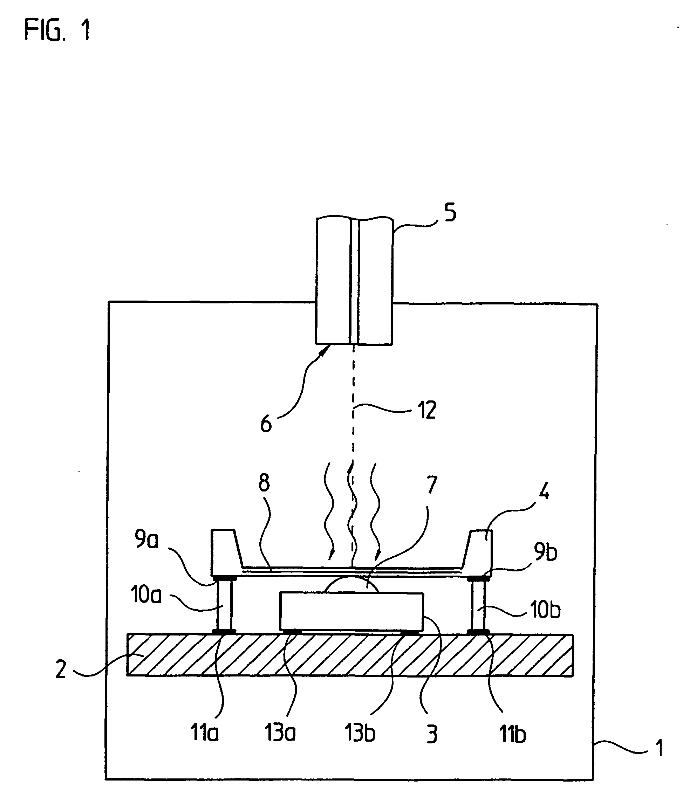

Anhand der schematisierten Darstellung von Figur 1 sei nachfolgend eine erste Ausführungsform der erfindungsgemäßen optoelektronischen Sende- und Empfangseinheit erläutert.
Hierbei ist einem geeigneten Gehäuse 1 ein Trägerelement 2 angeordnet, das beispielsweise als Leiterplatte bzw. Platine ausgebildet ist. Die wesentlichen Elemente der vorliegenden Erfindung sind auf dem Trägerelement 2 angeordnet, wobei das Trägerelement 2 neben der mechanischen Träger- und Stabilisierungsfunktion desweiteren auch zur Kontaktierung der darauf angeordneten optoelektronischen Bauteile dient. Hierzu sind entsprechende Leiterbahnen im Trägerelement 2 vorgesehen, welche in Figur 1 jedoch nicht erkennbar sind. Als wesentliche funktionsrelevante Bauteile der erfindungsgemäßen optoelektronischen Sende- und Empfangseinheit sind auf dem Trägerelement 2 eine Sendeeinheit 3 sowie eine Empfangseinheit 4 vorgesehen, die in einer bestimmten räumlichen Relativorientierung zu einem Lichtwellenleiter 5 orientiert sind bzw. zu dessen Endfläche 6, die der optoelektronischen Sende- und Empfangseinheit zugewandt ist. Der Lichtwellenleiter 5 weist in diesem Ausführungsbeispiel einen zweiteiligen Aufbau auf, bestehend aus einem Lichtwellenleiter-Kern und einem Lichtwellenleiter-Mantel. Die Endfläche 6 des Lichtwellenleiters wird durch geeignete konstruktive Maßnahmen in einer festen Relativorientierung in Bezug auf die Sende- und Empfangseinheit 3, 4 gehalten. Hierfür kommen verschiedenste Möglichkeiten in Betracht, beispielsweise geeignete Steckverbindungen etc. Verschiedene Möglichkeiten existieren dabei selbstverständlich auch im Zusammenhang mit dem Aufbau des jeweils eingesetzten Lichtwellenleiters.

Die Sendeeinheit 3 als auch die Empfangseinheit 4 sind nunmehr beide benachbart entlang einer gemeinsamen Achse 12 angeordnet, die im dargestellten Ausführungsbeispiel durch die optische Symmetrieachse des Lichtwellenleiters 5 definiert ist. Aufgrund dieser Anordnung erübrigt sich ein optisches Verzweiger-Element, wie es ansonsten üblicherweise zum Umlenken der vom Lichtwellenleiter 5 kommenden Strahlung auf die Empfangseinheit 4 sowie zum Umlenken und Einkoppeln der von der Sendeeinheit 3 emittierten Strahlung in den Lichtleiter 5 erforderlich ist.

Darüberhinaus ist insbesondere aufgrund der Wahl einer bestimmten Empfangseinheit 4 und der entsprechenden Anordnung derselben in Bezug auf die optische Achse 12 sichergestellt, daß die Relativausrichtung der Empfangseinheit 4 zur Endfläche 6 des Lichtwellenleiters 5 mit relativ großen Toleranzen möglich ist. So weist die gewählte optoelektronische Empfangseinheit 4 einen - lediglich schematisch angedeuteten - strahlungsempfindlichen Schichtbereich 8 auf, der in der Ebene einer dünnen Membran liegt und senkrecht zur optischen Achse 12 angeordnet ist. Die Ebene des aktiven Schichtbereiches 8 bzw. die strahlungsempfindliche Fläche, in der durch den Einfall der angedeuteten Strahlung die Signalerzeugung erfolgt, ist also senkrecht zur Zeichenebene orientiert. Die strahlungsempfindliche Fläche der Empfangseinheit 4, die demzufolge der flächigen Ausdehnung des aktiven Schichtbereiches 8 entspricht, ist somit insbesondere relativ groß gegenüber der Austrittsfläche des jeweiligen Lichtwellenleiters, d.h. im gezeigten Fall gegenüber dem Kernbereich bzw. der Kemfläche in der Endfläche 6. Insgesamt resultiert aufgrund dieser Anordnung deshalb ein deutlich verringerter Justieraufwand, was die exakte Relativpositionierung der Empfangseinheit 4 zum strahlungsemittierenden Bereich der Endfläche 6 des Lichtwellenleiters 5 betrifft. An dieser Stelle kann etwa eine übliche Steckverbindung eingesetzt werden, da keine hohen Justageanforderungen in Bezug auf die Relativausrichtung von Lichtwellenleiter 5 und Empfangseinheit 4 resultieren.

Wie bereits erwähnt, wird dies in erster Linie durch die erfindungsgemäße Wahl der optoelektronischen Empfangseinheit 4 ermöglicht. Im Hinblick auf eine detaillierte Beschreibung dieses Bauelementes sei an dieser Stelle ausdrücklich auf die WO 96/36999 der Anmelderin verwiesen.

Der Membranbereich der Empfangseinheit 4 mit dem aktiven, strahlungsempfindlichen Schichtbereich 8 ist hierbei derart dünn ausgebildet, in einer möglichen Ausführungsform etwa in der Größenordnung um 2µm, daß ein Durchstrahlen dieses Membranbereiches durch die Sendeeinheit 4 möglich ist. Die Sendeeinheit 3 ist demzufolge ebenfalls entlang der optischen Achse 12 angeordnet, und zwar hinter der Empfangseinheit 4, wenn die Anordnung vom Lichtleiter 5 aus betrachtet wird. Im strahlungsemittierenden Oberflächenbereich der Sendeeinheit 3 ist im gezeigten Ausführungsbeispiel eine Strahlformungsoptik 7 vorgesehen, die etwa als Linse mit geeigneten optischen Eigenschaften ausgebildet sein kann.
Alternativ hierzu wäre es auch möglich, die Strahlformungsoptik 7 an dieser Stelle mit einem sog. optischen Gel auszubilden. Daneben könnte die Strahlformungsoptik 7 auch als Fresnelstruktur oder als Gitterstruktur auf der Membranunterseite, d.h. auf der der Sendeeinheit 3 zugewandten Seite der Empfangseinheit 4 ausgebildet werden, die zu diesem Zweck entsprechend zu strukturieren wäre.

Im wesentlichen bewirkt die Strahlformungsoptik 7 eine Fokussierung der von der optoelektronischen Sendeeinheit 3 emittierten Strahlung auf die Endfläche 6 des Lichtwellenleiters 5. Desweiteren lassen sich im Fall der Verwendung eines optischen Gels an dieser Stelle auch Reflexionen an den verschiedenen Grenzflächen bzw. Luftspalte vermeiden, die jeweils eine Veringerung des Wirkungsgrades bewirken würden.
Im dargestellten, ersten Ausfführungsbeispiel wurde die geometrische Dimensionierung der aktiven, strahlungsempfindlichen Fläche der Empfangseinheit 4 desweiteren so gewählt, daß diese Fläche die benötigte Fläche der Sendeeinheit auf dem Trägerelement 2 überdeckt. Dadurch ergibt sich neben einer einfachen Montage der Gesamtanordnung auch eine Möglichkeit zur Kontaktierung der verschiedenen optoelektronischen Bauelemente auf dem Trägerelement 2.

Als Sendeeinheit 3 kommen grundsätzlich verschiedenste optoelektronische Halbleiter-Bauelemente in Betracht, z.B. LEDs, Laserdioden etc.

Da die Relativjustierung der Sendeeinheit 3 zum Lichtwellenleiter 5 aufgrund der üblichen Abstrahlcharakteristik derartiger Bauteile in der Regel weniger problematisch ist als die Justierung - konventioneller - Empfangseinheiten, ist es im Rahmen der vorliegenden Erfindung nicht zwingend erforderlich, daß auch die aktiven, strahlungsemittierenden Schichtbereiche der Sendeeinheit 3 senkrecht zur optischen Achse 12 ausgerichtet werden. Es könnten demzufolge sowohl Sendeeinheiten 3 entlang der optischen Achse 12 angeordnet werden, bei denen der aktive, strahlungsemittierende Schichtbereich in Verlängerung der optischen Achse 12, parallel oder aber senkrecht hierzu orientiert ist.

Im Rahmen der vorliegenden Erfindung können zur bidirektionalen Datenübertragung verschiedenste Kombinationen der Sende- und Empfangs-Wellenlängen eingesetzt werden.
So ist es beispielsweise möglich, die Sende- und Empfangseinheit 3, 4 derart auszuwählen und damit die entsprechenden Sende- und Empfangs-Wellenlängen λ_{S}, λ_{E}, daß diese möglichst jeweils nicht die andere Einheit beeinflußen. Je nach verwendeten Halbleitermaterialien in den beiden optoelektronischen Bauteilen ändert sich die emittierte Wellenlänge λ_{S} der Sendeeinheit 3 bzw. die Ansprechcharakteristik der Empfangseinheit 4 und damit deren Wellenlänge λ_{E} mit maximaler Ansprechempfindlichkeit.
So kann in einer möglichen Ausführungsform der erfindungsgemäßen Vorrichtung vorgesehen werden, daß die emittierte Wellenlänge λ_{S} der Sendeeinheit 3 möglichst nicht mit der Wellenlänge λ_{E} zusammenfällt, bei der die Empfangseinheit 4 primär anspricht. Im Fall einer derartigen Wahl der jeweiligen Wellenlängen λ_{S}, λ_{E} wäre der sog. Voll-Duplex-Betrieb der erfindungsgemäßen optoelektronischen Sende- und Empfangseinheit möglich, d.h. das gleichzeitige Senden und Empfangen von Daten über den angekoppelten Lichtwellenleiter 5.

Alternativ ist jedoch auch möglich, die jeweiligen Wellenlängen λ_{S}, λ_{E} bzw. Wellenlängenbereiche nicht derart aufeinander abzustimmen und durch eine geeignete zeitliche Ansteuerung der beiden Halbleiter-Bauelemente 3, 4 sicherzustellen, daß im Verlauf der Signalübertragung entweder nur gesendet oder nur empfangen wird. Dies entspräche dann einem sog. Halb-Duplex-Betrieb der erfindungsgemäßen optoelektronischen Sende- und Empfangseinheit.

In einer möglichen Ausführungsform beim Halb-Duplex-Betrieb wäre z.B. eine Sendeeinheit 2 vorgesehen, für die λ_{S} = 850nm gilt. Die maximale Empfindlichkeit der Empfangseinheit 4 liegt dann im gleichen Wellenlängenbereiche, d.h. λ_{E} = 850nm. Die Dicke des strahlungsempfindlichen Schichtbereiches in der Empfangseinheit 4 würde in diesem Fall dann etwa 2 µm gewählt, was im Membranbereich einen Transmissionsgrad von 50% bei den gewählten Wellenlängen λ_{S}, λ_{E} = 850nm zur Folge hat.

In Bezug auf die optoelektronischen Sende- und Empfangseinheiten 3, 4 existieren im Rahmen der vorliegenden Erfindung somit eine Reihe von Wahlmöglichkeiten.

Im Ausführungsbeispiel der Figur 1 erfolgt die Kontaktierung der Sende- und Empfangseinheit 3, 4 stets von der Rückseite der jeweiligen -einheiten her. Unter Rückseite sei dabei diejenige Seite verstanden, die abgewandt zum Lichtwellenleiter 5 orientiert ist. So sind auf der Rückseite der Sendeeinheit 3 schematisch Kontaktierungselemente 13a, 13b angedeutet, über die die Sendeeinheit 3 mit Leiterbahnen im Trägerelement 2 und damit mit einer nachgeordneten Ansteuer- und Auswerteeinheit verbunden ist, welche in Fig.1 ebenfalls nicht gezeigt ist. Ebenfalls auf ihrer Rückseite weist die Empfangseinheit 4 Kontaktierungselemente 9a, 9b auf, die wiederum mit elektrisch leitenden Abstandshaltern 10a, 10b verbunden sind. Am entgegengesetzten Ende sind die Abstandshalter 10a, 10b über weitere Kontaktierungselemente 11a, 11 b ebenfalls mit Leiterbahnen im Trägerelement 2 verbunden, über die die elektrische Verbindung der Empfangseinheit mit der erwähnten Ansteuer- und Auswerteeinheit hergestellt werden.
Eine derartige Kontaktierung der beiden Halbleiter-Bauelemente 3, 4 erweist sich insofern als vorteilhaft, als diese hierbei relativ einfach über bekannte SMD-Bestückungsverfahren auf dem Trägerelement 2 bzw. der Platine montiert werden können.

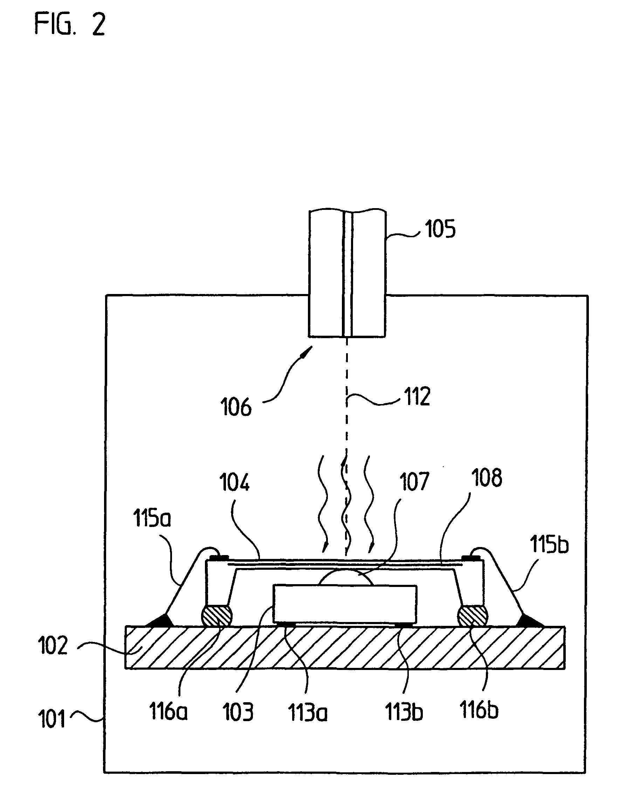

Eine alternative, zweite Ausführungsform der erfindungsgemäßen Vorrichtung ist in Figur 2 schematisch dargestellt. Diese unterscheidet sich im wesentlich nur in der Art der elektrischen Kontaktierung der auf dem Trägerelement 102 im Gehäuse 101 angeordneten Sende- und Empfangseinheiten 103, 104. Während hierbei die Kontaktierung der Sendeeinheit 103 wiederum mit Hilfe der rückseitig angeordneten Kontaktierungselemente 113a, 113b erfolgt, ist lediglich für die Empfangseinheit 104 eine alternative Kontaktierungsvariante vorgesehen. So ist die Empfangseinheit 104 über isolierende Elemente 116a, 116b auf dem Trägerelement 102 befestigt, während die Kontaktierung über Bonddrähte 115a, 115b erfolgt, die bei der Empfangseinheit 104 auf derjenigen Seite angeordnet sind, die der zu detektierenden Strahlung entgegengerichtet sind, also auf deren Vorderseite.

Ansonsten entspricht auch diese Ausführungsform der erfindungsgemäßen Vorrichtung der vorhergehenden Variante in Bezug auf die Relativanordnung der verschiedenen Elemente bezüglich der Achse 112 etc..

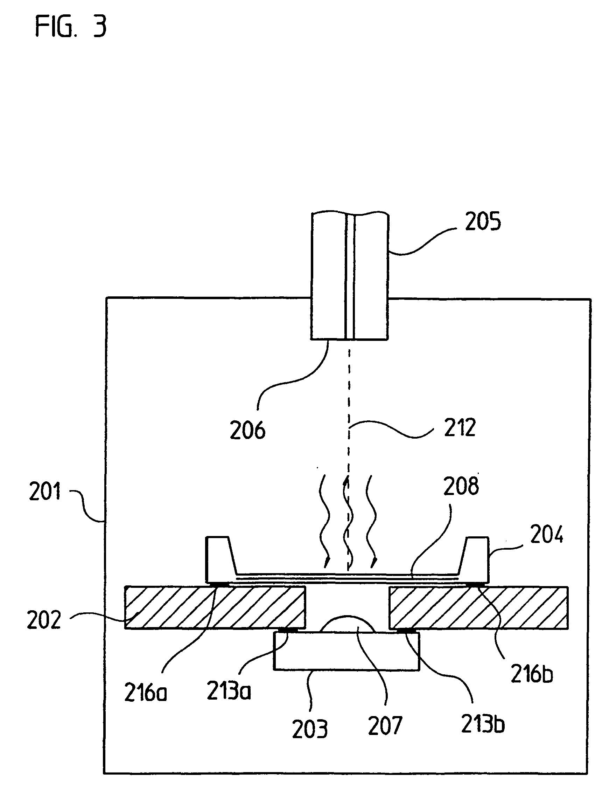

Eine dritte Ausführungsform der erfindungsgemäßen optoelektronischen Sende- und Empfangseinheit ist in Figur 3 schematisch gezeigt. Auch dieses Ausführungsbeispiel unterscheidet sich primär in der gewählten Art und Weise der Kontaktierung der Sende- und Empfangseinheit 203, 204 von den vorhergehenden Varianten und bietet lediglich hinsichtlich der möglichen vollautomatischen SMD-Bestückung bestimmte Vorteile.

So ist nunmehr ein Trägerelement 203 im Gehäuse 201 vorgesehen, das in einem Teilbereich eine Öffnung bzw. Aussparung 220 aufweist. Im Bereich dieser Öffnung sind die Sendeeinheit 203 als auch die Empfangseinheit 204 angeordnet. Hierbei erfolgt die Anordnung der Sendeeinheit 203 auf derjenigen Seite des Trägerelementes 202, die abgewandt zum Lichtwellenleiter 205 orientiert ist. Im Bereich der Öffnung 220 ist die als Linse ausgebildete Strahlformungsoptik 207 angeordnet.
Die Kontaktierung der Sendeeinheit 204 wird über Kontaktierungselemente 2013a, 213b vorgenommen, die auf der Vorderseite der Sendeeinheit 204 angeordnet sind, d.h. auf derjenigen Seite, die dem Lichtwellenleiter 205 zugewandt ist. Die Sendeeinheit 204 wird in dieser Ausführungsform demzufolge frontseitig kontaktiert.
Die optoelektronische Empfangseinheit 204 hingegen wird wiederum von derjenigen Seite her kontaktiert und mit dem Trägerelement 202 verbunden, die abgewandt zum Lichtwellenleiter 205 bzw. dessen Endfläche 206 orientiert ist. Hierzu sind zwischen der Rückseite der Empfangseinheit 204 und dem Trägerelement 202 und den darin angeordneten Leiterbahnen entsprechende Kontaktierungselemente 216a, 216b vorgesehen.

Ansonsten entspricht auch dieses Ausführungsbeispiel in Bezug auf die Anordnung der einzelnen Komponenten etc. den bereits oben beschriebenen Varianten.

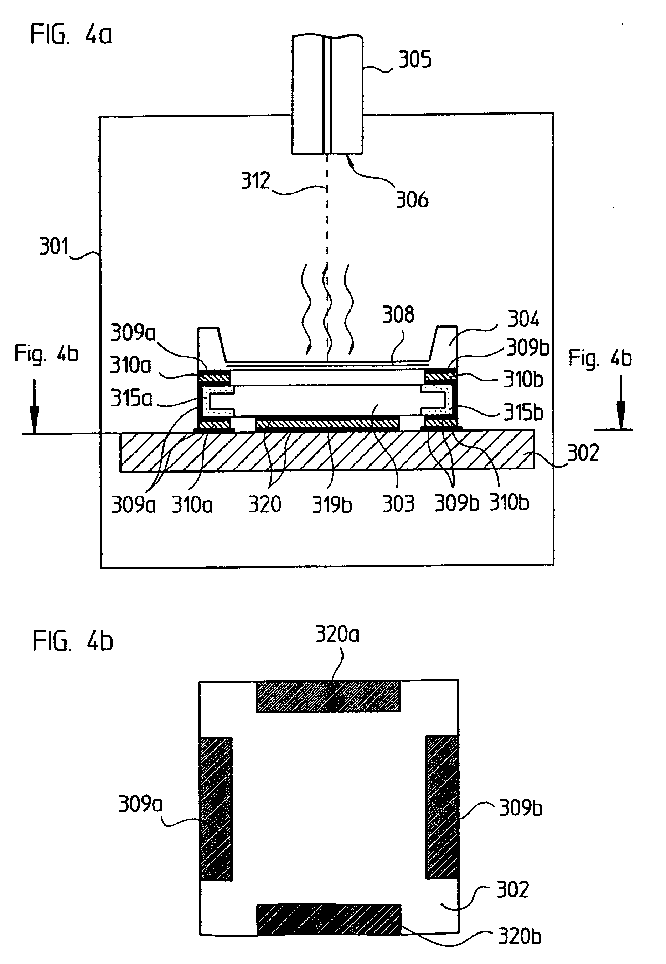

Eine vierte Ausführungsform der erfindungsgemäßen optoelektronischen Sende- und Empfangseinheit zeigen die Figuren 4a und 4b in verschiedenen Ansichten. Die wesentlichen Unterschiede zu den vorher beschriebenen Varianten sind wiederum in der Art und Weise der Kontaktierung der Sende- und Empfangseinheit 303, 304 zu sehen.

So erfolgt die Anordnung der Sendeeinheit 303 auf einem Trägerelement 302, wobei zur Kontaktierung dieses Elementes 302 rechteckförmige Kontaktierungelemente 320a, 320b sowohl auf Seiten der Sendeeinheit 303 als auch auf Seiten des Trägerelementes 302 vorgesehen sind. Über ein dazwischen angeordnetes leitfähiges Kontaktierungsmaterial 319b, etwa ein geeignetes Lot, wird die leitende Verbindung zu Leiterbahnen im Trägerelement 302 hergestellt. Die Kontaktierungsbereiche 320a, 320b sind hierbei an gegenüberliegenden Seiten der Sendeeinheit 303 angeordnet. Um 90° verdreht hierzu ist ein weiteres Paar von Kontaktierungselementen 309a, 309b für die Empfangseinheit 304 vorgesehen, zwischen denen jeweils wiederum ein leitfähiges Kontaktierungsmaterial 310a, 310b angeordnet wird. Diese Kontaktierungselemente 309a, 309b dienen demzufolge zur Kontaktierung der über der Sendeeinheit 303 angeordneten Empfangseinheit 304. Auf jeder Seite sind dabei insgesamt drei Kontaktierungselemente 309a, 309b angeordnet, jeweils eines an der Unterseite der Empfangseinheit 304, an der Seitenfläche der Sendeeinheit 303 sowie auf dem Trägerelement 302. Um zu verhindern, daß insbesondere die an den Seitenflächen der Sendeeinheit 303 angeordneten Kontaktierungselemente 309a, 309b in Kontakt mit der Sendeeinheit 303 kommen, sind an den entsprechenden Seitenflächen der Sendeeinheit 303 U-förmige Isolierungselemente 315a, 315b angeordnet, die diesen Bereich umgreifen.
In Bezug auf den weiteren, prinzipiellen Aufbau, also etwa der Anordnung des strahlungsempfindlichen Schichtbereiches 308 in der Empfangseinheit 304 entspricht auch dieses Ausführungsbeispiel den vorab erläuterten Varianten. Selbstverständlich kann dabei auch wiederum eine geeignete Strahlformungsoptik zwischen Sendeeinheit 303 und Empfangseinheit 304 angeordnet werden etc..

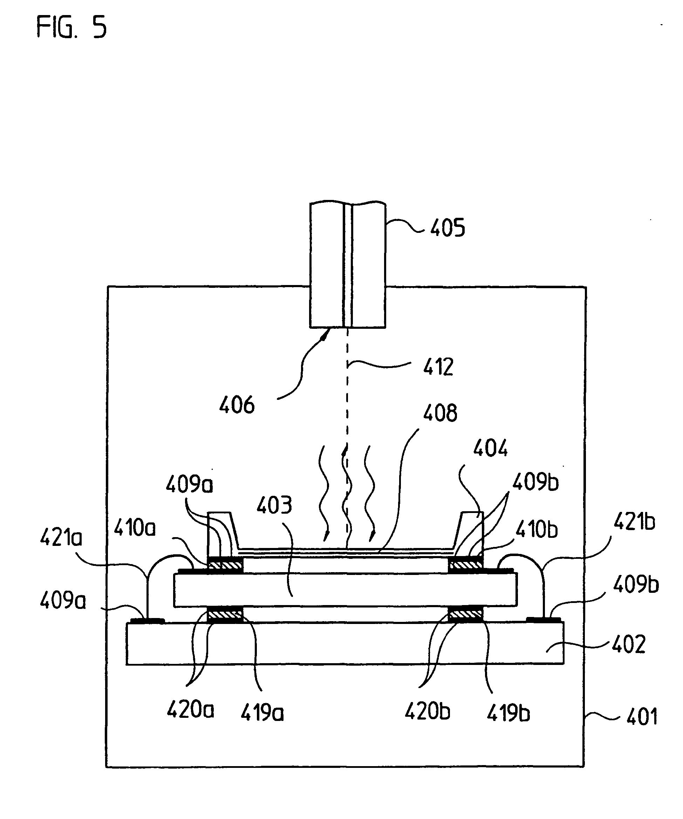

Eine weitere optoelektronische Sende- und Empfangseinheit ist in Figur 5 schematisch dargestellt. Nachfolgend sei lediglich auf die spezielle Art der Kontaktierung der verschiedenen Bauelemente eingegangen; der grundsätzliche Aufbau ist identisch mit dem der vorhergehenden Ausführungsformen.
In diesem Fall ist nunmehr eine Sendeeinheit 403 auf einem Trägerelement 402 angeordnet, dessen Gesamtfläche größer ist als die der darüber angeordneten Empfangseinheit 404. Aufgrund dieser Anordnung ist die Kontaktierung der Empfangseinheit 404 über Bonddrähte 421 a, 42b möglich, die verschiedene Kontaktierungselemente 409a, 409b miteinander verbinden. Die Kontaktierungselemente 409a, 409b sind hierbei auf der Unterseite der Empfangseinheit 404, auf Teilbereichen der Oberseite der Sendeeinheit 403 sowie auf dem Trägerelement 402 angeordnet. Über die Bonddrähte 421 a, 421 b wird eine leitfähige Verbindung zwischen den Kontaktierungselementen auf der Oberseite der Sendeeinheit 403 und denjenigen auf dem Trägerelement 402 hergestellt. Zwischen den Kontaktierungselementen 409a, 409b auf der Unterseite der Empfangseinheit 404 und den auf der Oberseite der Sendeeinheit 403 angeordneten Kontaktierungselementen 409a, 409b ist wiederum ein elektrisch leitfähiges Kontaktierungsmaterial 410a, 410b vorgesehen. Die Kontaktierung der Sendeeinheit 403 erfolgt über Kontaktierungselemente 420a, 420b , die zum einen auf der Unterseite der Sendeeinheit 403 und auf dem Trägerelement 402 angeordnet sind; dazwischen ist jeweils ein leitfähiges Kontaktierungsmaterial 419a, 419b vorgesehen.
Während in sämtlichen vorhergehenden Ausführungbeispielen die Kontaktierung der Empfangseinheit durch eine geeignete geometrische Ausbildung und/oder Anordnung der beiden Einheiten sowie durch eine geeignete Anordnung verschiedener Kontaktierungselemente etc. erfolgte, wäre auch eine grundlegend alternative Ausführungsform hierzu möglich. So könnten z.B. geeignete Bohrungen oder schmale Löcher in Randbereichen der Sendeeinheit angebracht werden, die mit leitfähigem Kontaktierungsmaterial gefüllt werden und derart ein Kontaktieren der oben liegenden Empfangseinheit durch die Sendeeinheit hindurch ermöglichen. Die hierzu erforderlichen Bohrungen bzw. Löcher könnten durch ein sog. Thermomigrationsverfahren oder aber durch Bohren mittels Laser hergestellt werden.

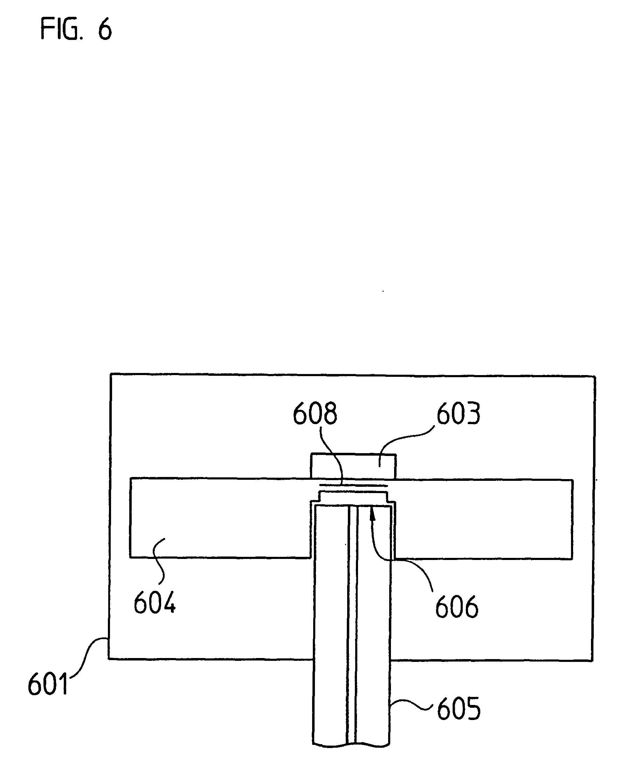

Eine weitere optoelektronische Sende- und Empfangseinheit sei abschließend anhand der Figur 6 in einer Teilansicht erläutert.
Gezeigt ist hierbei lediglich die in einem Gehäuse 601 befindliche Anordnung aus Sendeeinheit 603, Empfangseinheit 604 und Lichtwellenleiter 605. Der Lichtwellenleiter 605 bzw. dessen Endfläche 606 ist nunmehr direkt in einer Aussparung der Empfangseinheit 604 angeordnet. Die Aussparung ist hierbei in einem Bereich der Empfangseinheit 604 vorgesehen, in der sich auch der membranartige Teilbereich der Empfangseinheit 604 befindet, in dem der aktive Schichtbereich 608 angeordnet ist. Oberhalb der Membran mit dem aktiven Schichtbereich 608 wird die Sendeeinheit 603 angeordnet. Die strahlungsemittierende Fläche der Sendeeinheit 603 ist in Richtung der Aussparung bzw. der Endfläche 606 des Lichtwellenleiters 605 orientiert. Eine Kontaktierung der Sendeeinheit 603 erfolgt mit Hilfe von - nicht gezeigten - Kontaktierungselementen, die zwischen der lichtemittierenden Seite der Sendeeinheit 603 und der Empfangseinheit angeordnet sind. Die - ebenfalls nicht dargestellten - Kontaktierungselemente der Empfangseinheit 604 können beispielsweise daneben, d.h. auf der Oberseite der Empfangseinheit 604, angeordnet werden.
Die Kontaktierungselemente der beiden optoelektronischen Bauteile 603, 604 werden dann noch mit den entsprechenden Kontaktierungselementen auf einem Trägerelement im Gehäuse verbunden, welches in Figur 6 ebenfalls nicht gezeigt ist.
Eine Fixierung der gesamten Anordnung aus Lichtwellenleiter 605 und den beiden Einheiten 603, 604 könnte z.B. durch Verkleben oder aber Vergießen erfolgen.

Wie anhand der vorhergehenden Beschreibung mehrerer Ausführungsbeispiele deutlich wurde, existieren somit eine Reihe von Möglichkeiten, die vorliegende Erfindung vorteilhaft auszugestalten. Die im Zusammenhang mit den verschiedenen Ausführungsbeispielen erläuterten Maßnahmen lassen sich hierbei selbstverständlich auch geeignet kombinieren, so daß letztlich vielfältige Möglichkeiten zur Realisierung der vorliegenden Erfindung resultieren.

## Patentansprüche

1. Optoelektronische Sende- und Empfangseinheit zur bidirektionalen Datenübertragung mittels Lichtwellenleitern, bestehend aus einer optoelektronischen Sendeeinheit und einer optoelektronischen Empfangseinheit, die beide jeweils mindestens einen aktiven strahlungsempfindlichen oder strahlungsemittierenden Schichtbereich aufweisen, wobei die Sende- und Empfangseinheit entlang einer Strahlachse angeordnet sind und zumindest der aktive strahlungsempfindliche Schichtbereich der Empfangseinheit senkrecht zur Strahlachse angeordnet ist,
**dadurch gekennzeichnet, dass**
- die Sendeeinheit (3; 103; 203; 303) auf einem Trägerelement (2; 102; 202; 302) angeordnet ist, wobei die Sendeeinheit (3; 103; 203; 303) auf dem Trägerelement (2; 102; 202) eine bestimmte Fläche benötigt und
- die Empfangseinheit (4; 104; 204; 304) in Richtung der Endfläche (6; 106; 206; 306) eines Lichtwellenleiters (5; 105; 205; 305) brückenartig über der Sendeeinheit (3; 103; 203; 303) angeordnet ist, wobei die aktive, strahlungsempfindliche Fläche der Empfangseinheit (4; 104; 204; 304) die benötigte Fläche der Sendeeinheit (3; 103; 203; 303) auf dem Trägerelement (2; 102; 202; 302) überdeckt und
- der aktive Schichtbereich (8; 108; 208; 308) der Empfangseinheit (4; 104; 204; 304) sich in einer dünnen Membran befindet, die unmittelbar vor dem lichtemittierenden Bereich der Sendeeinheit (3; 103; 203; 303) angeordnet ist und derart zumindest ein Teil der emittierten Strahlung die Membran in Richtung des Lichtwellenleiters (5; 105; 205; 305) durchtritt.

2. Optoelektronische Sende- und Empfangseinheit nach Anspruch 1, **dadurch gekennzeichnet, dass** zwischen der Membran und dem lichtemittierenden Bereich der Sendeeinheit (3; 103; 203) ein optisches Strahlformungselement (7; 107; 207) angeordnet ist.

3. Optoelektronische Sende- und Empfangseinheit nach Anspruch 2, **dadurch gekennzeichnet, dass** das optische Strahlformungselement (7; 107; 207) als Linse mit fokussierender Wirkung ausgebildet ist.

4. Optoelektronische Sende- und Empfangseinheit nach Anspruch 2, **dadurch gekennzeichnet, dass** das optische Strahlformungselement (7; 107; 207) aus einem optischen Gel gebildet ist.

5. Optoelektronische Sende- und Empfangseinheit nach Anspruch 1, **dadurch gekennzeichnet, dass** Sende- und Empfangseinheit auf dem Trägerelement (2; 102; 202; 302) angeordnet sind und desweiteren elektrisch leitfähige Kontaktierungselemente (9a, 9b, 11a, 11 b, 13a, 13b; 113a, 113b, 115a, 115b; 216a, 216b, 213a, 213b; 309a, 309b, 320a, 320b) zwischen der Sende- und Empfangseinheit einerseits und und elektrischen Leiterbahnen im Trägerelement (2; 102; 202; 302) andererseits vorhanden sind.

6. Optoelektronische Sende- und Empfangseinheit nach Anspruch 1, **dadurch gekennzeichnet, dass** die strahlungsempfindliche Fläche der Empfangseinheit (4; 104; 204; 304) größer als der strahlungsemittierende Teilbereich der Endfläche des Lichtwellenleiters (5; 105; 205; 305), aus der die zu detektierende Strahlung ausgekoppelt wird.

7. Optoelektronische Sende- und Empfangseinheit nach Anspruch 1, **dadurch gekennzeichnet, dass** auch der aktive lichtemittierende Schichtbereich der Sendeeinheit senkrecht zur Strahlachse angeordnet ist.

8. Optoelektronische Sende- und Empfangseinheit nach Anspruch 5, **dadurch gekennzeichnet, dass** das Trägerelement (202) eine Aussparung aufweist und der strahlungsemittierende Bereich der Sendeeinheit (203) als auch zumindest ein Teil des aktive Schichtbereiches (208) der Empfangseinheit (204) im Bereich dieser Aussparung angeordnet ist, wobei die Sende- und Empfangseinheit (203, 204) auf den beiden unterschiedlichen Seiten des Trägerelementes (202) angeordnet sind.

## Claims

1. Optoelectronic transmitter and receiver unit for bidirectional data transfer by means of optical waveguides, comprising an optoelectronic transmitter unit and an optoelectronic receiver unit, which both respectively have at least one active radiation-sensitive or radiation-emitting layer region, wherein the transmitter and receiver unit are arranged along a beam axis, and at least the active radiation-sensitive layer region of the receiver unit is arranged perpendicular to the beam axis,
**characterised in that**
• the transmitter unit (3; 103; 203; 303) is arranged on a support element (2; 102; 202; 302), wherein the transmitter unit (3; 103; 203; 303) requires a specific area on the support element (2; 102; 202; 302), and
• the receiver unit (4; 104; 204; 304) is arranged in a bridge-like manner above the transmitter unit (3; 103; 203; 303) in the direction of the end face (6; 106; 206; 306) of an optical waveguide (5; 105; 205; 305), wherein the active radiation-sensitive surface of the receiver unit (4; 104; 204; 304) covers the required area of the transmitter unit (3; 103; 203; 303) on the support element (2; 102; 202; 302), and
• the active layer region (8; 108; 208; 308) of the receiver unit (4; 104; 204; 304) is located in a thin membrane, which is arranged directly in front of the light-emitting region of the transmitter unit (3; 103; 203; 303), and in such a way at least a portion of the emitted radiation passes through the membrane in the direction of the optical waveguide (5; 105; 205; 305).

2. Optoelectronic transmitter and receiver unit according to Claim 1, **characterised in that** an optical beam shaping element (7; 107; 207) is arranged between the membrane and the light-emitting region of the transmitter unit (3; 103; 203).

3. Optoelectronic transmitter and receiver unit according to Claim 2, **characterised in that** the optical beam shaping element (7; 107; 207) is configured as a lens with focussing effect.

4. Optoelectronic transmitter and receiver unit according to Claim 2, **characterised in that** the optical beam shaping element (7; 107; 207) is formed from an optical gel.

5. Optoelectronic transmitter and receiver unit according to Claim 1, **characterised in that** the transmitter and receiver unit are arranged on a support element (2; 102; 202; 302) and additionally electrically conductive contacting elements (9a, 9b, 11a, 11b, 13a, 13b; 113a, 113b, 115a, 115b; 216a, 216b, 213a, 213b; 309a, 309b, 320a, 320b) are present between the transmitter and receiver unit, on one side, and the electrical conductor tracks in the support element (2; 102; 202; 302), on the other side.

6. Optoelectronic transmitter and receiver unit according to Claim 1, **characterised in that** the radiation-sensitive surface of the receiver unit (4; 104; 204; 304) is larger than the radiation-emitting sub-region of the end face of the optical waveguide (5; 105; 205; 305), from which the radiation to be detected is coupled out.

7. Optoelectronic transmitter and receiver unit according to Claim 1, **characterised in that** the active light-emitting layer region of the transmitter unit is also arranged perpendicular to the beam axis.

8. Optoelectronic transmitter and receiver unit according to Claim 5, **characterised in that** the support element (202) has a recess and the radiation-emitting region of the transmitter unit (203) as well as at least a portion of the active layer region (208) of the receiver unit (204) is arranged in the region of this recess, wherein the transmitter and receiver unit (203, 204) are arranged on the two different sides of the support element (202).

## Revendications

1. Unité d'émission et de réception optoélectronique, destinée à la transmission de données bidirectionnelle à l'aide de fibres optiques et constituée d'une unité d'émission optoélectronique et d'une unité de réception optoélectronique, qui présentent toutes deux au moins une zone de couche active sensible au rayonnement ou émettant un rayonnement, les unités d'émission et de réception étant disposées le long d'un axe de faisceau, et au moins la zone de couche active, sensible au rayonnement, de l'unité de réception étant placée perpendiculairement à l'axe de faisceau,
**caractérisée en ce que**
- l'unité d'émission (3; 103; 203; 303) est disposée sur un élément support (2; 102; 202; 302), l'unité d'émission (3; 103; 203; 303) nécessitant une superficie définie sur l'élément support (2; 102; 202), et
- l'unité de réception (4; 104; 204; 304) est disposée à la manière d'un pont au-dessus de l'unité d'émission (3; 103; 203; 303), en direction de la face d'extrémité (6; 106; 206; 306) d'une fibre optique (5; 105; 205; 305), la surface active, sensible au rayonnement, de l'unité de réception (4; 104; 204; 304) recouvrant la superficie requise par l'unité d'émission (3; 103; 203; 303) sur l'élément support (2; 102; 202; 302), et
- la zone de couche (8; 108; 208; 308) active de l'unité de réception (4; 104; 204; 304) se situe dans une membrane mince qui est disposée directement devant la zone émettrice de lumière de l'unité d'émission (3; 103; 203; 303), et une partie du rayonnement émis traversant ainsi la membrane en direction de la fibre optique (5; 105; 205; 305).

2. Unité d'émission et de réception optoélectronique selon la revendication 1, **caractérisée en ce qu'**un élément formateur de faisceau (7; 107; 207) optique est disposé entre la membrane et la zone émettrice de lumière de l'unité d'émission (3; 103; 203).

3. Unité d'émission et de réception optoélectronique selon la revendication 2, **caractérisée en ce que** l'élément formateur de faisceau (7; 107; 207) optique est réalisé sous forme de lentille à action focalisante.

4. Unité d'émission et de réception optoélectronique selon la revendication 2, **caractérisée en ce que** l'élément formateur de faisceau (7; 107; 207) optique est constitué d'un gel optique.

5. Unité d'émission et de réception optoélectronique selon la revendication 1, **caractérisée en ce que** les unités d'émission et de réception sont disposées sur l'élément support (2; 102; 202; 302) et qu'en outre, des éléments de connexion (9a, 9b, 11a, 11b, 13a, 13b; 113a, 113b, 115a, 115b; 216a, 216b, 213a, 213b; 309a, 309b, 320a, 320b) conducteurs du courant électrique sont prévus entre les unités d'émission et de réception, d'une part, et des pistes conductrices électriques situées dans l'élément support (2; 102; 202; 302), d'autre part.

6. Unité d'émission et de réception optoélectronique selon la revendication 1, **caractérisée en ce que** la surface sensible au rayonnement de l'unité de réception (4; 104; 204; 304) est plus grande que la zone partielle émettrice de rayonnement de la face d'extrémité de la fibre optique (5; 105; 205; 305), où le rayonnement à détecter est découplé.

7. Unité d'émission et de réception optoélectronique selon la revendication 1, **caractérisée en ce que** la zone de surface active, émettrice de lumière, de l'unité d'émission est également disposée perpendiculairement à l'axe de faisceau.

8. Unité d'émission et de réception optoélectronique selon la revendication 5, **caractérisée en ce que** l'élément support (202) présente un évidement et la zone émettrice de rayonnement de l'unité d'émission (203) ainsi qu'au moins une partie de la zone de surface active (208) de l'unité de réception (204) sont disposées dans la région de cet évidement, les unités d'émission et de réception (203, 204) étant disposées sur les deux faces opposées de l'élément support (202).
